# EUROPÄISCHE PATENTANMELDUNG

(11) **EP 2 200 411 A1**
(43) Veröffentlichungstag der Anmeldung: **23.06.2010**
(21) Anmeldenummer: 08172223.3
(22) Anmeldetag: 19.12.2008
(51) Int. Cl.: H05K 1/11, H05K 3/46

(54) **Leiterplatte**

(71) Anmelder: Siemens Aktiengesellschaft, 80333 München (DE)
(72) Erfinder: Chowaniec, Michael, 09126, Chemnitz (DE); Rohne, Klaus, 09350, Lichtenstein (DE)

(57) **Zusammenfassung**

Um bei einer Leiterplatte (20) umfassend einen aus einer Mehrzahl von Strukturschichten (1,...,9) ausgebildeten Lagenaufbau, eine Packungsdichte für ein Steckmittel zur Kontaktierung über Kontaktflächen, welche mit den Leiterbahnen (24) in Verbindung stehen, wird vorgeschlagen, dass die Strukturschichten (1,...,9) in einem Randbereich als ein treppenförmiges Profil zur Aufnahme des Steckmittels ausgebildet sind.

## Beschreibung

Die Erfindung betrifft eine Leiterplatte umfassend einen aus einer Mehrzahl von Strukturschichten ausgebildeten Lagenaufbau.

In der Elektroindustrie werden elektronische Geräte mit einer immer größer werdenden Funktionsdichte entwickelt, daraus ergibt sich im gleichen Maße eine steigende Packungsdichte von Kontaktelementen bei Steckverbindern, welche mit der Leiterplatte kontaktiert werden. Nach dem Stand der Technik erfolgt die Kontaktierung von Steckverbindern zu den Leiterplatten mittels Direktverbindungen, wobei Kontakte auf den Leiterplattenaußenflächen angeordnet sind und zur Kontaktierung ein Steckverbinder mit Kontaktelementen auf sie gesteckt wird. Bei dieser Art der Kontaktierung von Steckverbindern zu Kontakten auf der Leiterplatte ist der Packungsdichte der Kontaktelemente der Steckverbinder bzw. der Kontakte, welche auf der Leiterplatte angeordnet sind, aufgrund von beispielsweise UL-Zertifizierungen und der damit einzuhaltenen Luft- und Kriechstrecken für Ströme und der für die Leiterplatten einzuhaltenen spezifischen Eigenschaften, eine Grenze gesetzt.

Nach dem Stand der Technik wird zur Einhaltung der Luft- und Kriechstrecken eine Kontaktbreite, der auf den Leiterplattenaußenflächen angeordneten Kontakte, soweit wie möglich reduziert, wobei dadurch eine relativ geringe Abmessung der Steckverbinder nicht erreicht werden kann.

In der EP 0 393 312 A1 ist eine mehrlagige Leiterplatte mit mindestens zwei durch eine elektrisch isolierende Zwischenschicht voneinander beabstandeten Leiterbahn führenden Ebenen offenbart.

Es ist Aufgabe der Erfindung eine Leiterplatte anzugeben, bei welcher Kontaktflächen angeordnet sind um bei Herstellung einer Verbindung über ein lösbares Steckmittel zu der Leiterbahn eine maximierte Packungsdichte von Kontaktflächen zu erreichen.

Die Aufgabe wird dadurch gelöst, dass bei der eingangs genannten Leiterplatte die Strukturschichten in einem Randbereich derart versetzt zueinander angeordnet sind, dass ein treppenförmiges Profil zur Aufnahme eines Steckmittels ausgebildet ist. Durch die treppenförmige Ausbildung der Strukturschichten im Randbereich entsteht eine pyramidenförmige oder kaskadenartige Struktur wobei die Oberfläche für anzuordnende Kontaktflächen im Gegensatz zu einer einfachen Anordnung auf eine Oberseite und einer Unterseite der Leiterplatte vergrößert wird. Da mehrlagige Leiterplatten vorzugsweise aus mehreren Einzelleiterplatten mit ein- oder beidseitiger Kupferauflage für Leiterbahnen und beispielsweise einer Pre-Preg-Zwischenschicht bestehen, können bei diesem mehrlagigen Leiterplattenaufbau die Pre-Preg-Schicht für einen zusätzlichen Kontaktbereich zurückgenommen werden und damit der Leiterplattenaufbau nach außen hin treppenförmig für zusätzliche Kontaktflächen sich von Schicht zu Schicht aufbaut. Durch diesen treppenförmigen Aufbau im Randbereich lässt sich eine wesentlich höhere Kontaktdichte erreichen. So ist es jetzt möglich, dass über die Kontaktflächen, welche sich auf den einzelnen Treppenstufen der Leiterplatte befinden, zusätzliche Verbindungspunkte von der Leiterplatte zu einem Steckverbinder herzustellen. Die Verbindungen über einen Steckverbinder werden üblicherweise zur Kontaktierung und damit zur Signalübertragung von beispielsweise auf der Leiterplatte durch Mikroprozessoren erzeugte Signale zur Weiterleitung an ein vorzugsweise neben der Leiterplatte angeordnetes zusätzliches Auswertesystem genutzt.

In einer bevorzugten Ausgestaltung ist die Leiterplatte derart ausgestaltet, dass der Lagenaufbau als ein wechselnder Aufbau aus einer Zwischenschicht und einer eine Leiterbahn tragenden Schicht ausgestaltet ist, und die Schichten aufeinanderliegen. Dabei ist es von besonderem Vorteil wenn ausgehend von einer Längsachse des Lagenaufbaus auf eine eine Leiterbahn tragende Schicht eine Zwischenschicht folgt, wobei ausgehend von einem Mittel-Punkt der Längsachse und von einem Maximal-Punkt, welcher eine maximale Ausdehnung einer Schicht X-Richtung beschreibt, eine Zwischenschicht auf einer eine Leiterbahn tragenden Schicht versetzt angeordnet ist und der damit geschaffene freie Platz Raum für eine erste Kontaktfläche bildet.

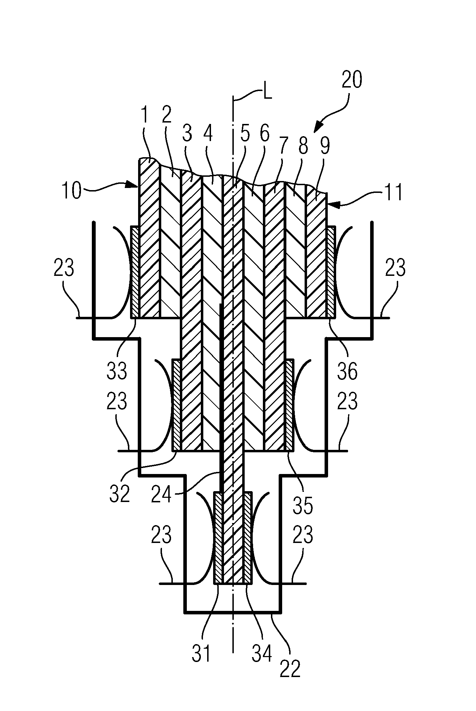

Weitere Vorteile und Merkmale der Erfindung werden anhand der Zeichnung erklärt.

Es zeigt die Figur einen prinzipiellen Aufbau einer Leiterplatte mit einem treppenförmigen Randbereich.

Gemäß der Figur ist ausschnittsweise eine Leiterplatte 20 in einer Schnittdarstellung abgebildet. Die Leiterplatte 20 weist eine erste Strukturschicht 1, diese ist als eine Leiterbahn tragende Schicht ausgestaltet, eine zweite Strukturschicht 2, welche als eine Zwischenschicht, eine sogenannte Pre-Preg-Schicht, ausgestaltet ist, die erste Strukturschicht 1 ist zurückversetzt angeordnet. Die Leiterplatte 20 ist mit ihren Strukturschichten 1, ..., 9 als eine in Sandwich-Bauweise aufgebaute mehrlagige Leiterplatte 20 ausgestaltet. Auf die zweite Strukturschicht 2 folgt eine dritte Strukturschicht 3, gefolgt von einer vierten Strukturschicht 4, weiterhin gefolgt von einer fünften Strukturschicht 5, wiederum gefolgt von einer sechsten Strukturschicht 6, gefolgt von einer siebten Strukturschicht 7, gefolgt von einer achten Strukturschicht 8 und abschließend mit einer neunten Strukturschicht 9 versehen. Die erste Strukturschicht 1 bildet dabei eine Oberseite 10 und die neunte Strukturschicht 9 bildet dabei eine Unterseite 11 der Leiterplatte 20.

Die erste, dritte, fünfte, siebte und neunte Strukturschicht sind jeweils als Leiterbahn tragende Strukturschichten ausgebildet. Die zweite, vierte, sechste und achte Strukturschicht sind jeweils als Zwischenschichten, sogenannte Pre-Preg-Schichten ausgestaltet. Die vierte Strukturschicht 4 bildet in diesem Beispiel die innerste Lage und bildet zugleich mit ihrer Mittenlinie eine Längsachse L, welche einer Symmetrieachse entspricht. Ausgehend von der Längsachse L ist ein linksseitiger treppenförmiger Verlauf und ein rechtsseitiger treppenförmiger Verlauf der Leiterplatte 20 im Randbereich angeordnet wodurch eine pyramidenförmige Struktur gebildet wird. Die fünfte Strukturschicht 5 ragt dabei über die vierte und sechste Strukturschicht 4,6 hinaus und hat durch ihre hinausragende Länge Platz für eine erste Kontaktfläche 31 linksseitig der Längsachse L und eine zweite Kontaktfläche 34 rechtsseitig der Längsachse L. Auf der zurückversetzten vierten Schichtstruktur 4 ist die dritte Schichtstruktur 3 angeordnet. Dabei ragt die dritte Schichtstruktur 3 über die maximale Ausdehnung der zweiten Schichtstruktur 2 hinaus und bildet somit einen Raum für ein zweites Kontaktelement 32. Die erste Schichtstruktur 1 ist gleichzusetzen mit der Oberseite 10 der Leiterplatte 20 auf dem sich ein drittes Kontaktelement 33 befindet.

Rechtsseitig der Längsachse L ergibt sich für eine vierte Kontaktfläche 34, eine fünfte Kontaktfläche 35 und eine sechste Kontaktfläche 36, ein zu dem linksseitigen kaskadenförmigen Aufbau analoger Aufbau.

Ein Steckmittel 22 ist über den treppenförmigen Verlauf der Leiterplatte 20 angeordnet. Das Steckmittel 22 trägt Kontakte 23, welche jeweils das gleiche Bezugszeichen tragen. In dem Steckmittel 22 sind die Kontakte 23 derart angeordnet, dass sie den jeweiligen Kontaktflächen gegenüberstehen und bei einem Draufschieben des Steckmittels 22 mit den Kontaktflächen 31, ..., 36 kontaktieren und somit eine leitende Verbindung herstellen.

## Patentansprüche

1. Leiterplatte (20) umfassend einen aus einer Mehrzahl von Strukturschichten (1, ..., 9) ausgebildeten Lagenaufbau,
**dadurch gekennzeichnet, dass** die Strukturschichten (1, ..., 9) in einem Randbereich derart versetzt zueinander angeordnet sind, dass ein treppenförmiges Profil zur Aufnahme eines Steckmittels (22) ausgebildet ist.

2. Leiterplatte (20) nach Anspruch 1,
wobei der Lagenaufbau als ein wechselnder Aufbau aus einer Zwischenschicht und einer eine Leiterbahn (24) tragenden Schicht ausgestaltet ist und die Schichten aufeinanderliegen.

3. Leiterplatte (20) nach Anspruch 2,
wobei ausgehend von einem Mittel-Punkt (y) einer Längsachse (L) und von einem Maximal-Punkt (x), welcher eine maximale Ausdehnung einer Schicht X-Richtung beschreibt, eine Zwischenschicht (2,4,6,8) auf einer eine Leiterbahn (24) tragenden Schicht (5) versetzt angeordnet ist und der damit geschaffene freie Platz Raum für eine erste Kontaktfläche (31) bildet.

4. Leiterplatte (20) nach Anspruch 3, wobei die Kontaktfläche (31) mit der Leiterbahn (24) in Verbindung steht.
